(19)

**Europäisches Patentamt**
**European Patent Office**
**Office européen des brevets**

(11) **EP 4 024 041 A1**

(12) **EUROPEAN PATENT APPLICATION**

(43) Date of publication:
**06.07.2022 Bulletin 2022/27**

(21) Application number: **20306709.5**

(22) Date of filing: **30.12.2020**

(51) International Patent Classification (IPC):
**G01N 24/08** $^{(2006.01)}$     **G01R 33/44** $^{(2006.01)}$

(52) Cooperative Patent Classification (CPC):
**G01N 24/081;** G01R 33/448

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicants:
- **ARMINES**
  **75272 Paris Cedex 06 (FR)**
- **Services Petroliers Schlumberger (SPS)**
  **75007 Paris (FR)**
  Designated Contracting States:
  **FR**
- **Schlumberger Technology B.V.**
  **2514 JG  The Hague (NL)**
  Designated Contracting States:
  **AL AT BE BG CH CY CZ DE DK EE ES FI GB GR HR HU IE IS IT LI LT LU LV MC MK MT NL NO PL PT RO RS SE SI SK SM TR**

(72) Inventors:
- **BILLIOTE, Joel**
  **95170 DEUIL LA BARRE (FR)**
- **AMMAR, Mahdi**
  **92140 CLAMART (FR)**
- **BREVIERE, Jerome**
  **92140 CLAMART (FR)**
- **BONDABOU, Karim**
  **92140 CLAMART (FR)**

(74) Representative: **Lavoix**
**2, place d'Estienne d'Orves**
**75441 Paris Cedex 09 (FR)**

(54) **METHOD FOR POROSITY ESTIMATION OF A GEOLOGICAL FORMATION FROM A NMR RELAXATION SPECTRUM, ASSOCIATED DEVICE**

(57)    The present disclosure concerns a method for porosity estimation of a geological formation implemented in a porosity estimation device. The method comprises, obtaining (110) data of an initial NMR relaxation spectrum of a rock sample taken from the geological formation and a measured porosity. The rock sample includes cuttings and liquid.

The method comprises decorrelating (120,130) a first contribution peak of free liquid and a second contribution peak in the NMR relaxation spectrum to obtain at least a second decorrelated NMR relaxation spectrum representative of pore's liquid disposed in intact pieces of rock of the cuttings.

The method comprises determining (144) a NMR integration correction factor from a contribution of the pore's liquid in the rock sample calculated (142) based on the second decorrelated NMR relaxation spectrum.

The method comprises estimating an estimated porosity from the measured porosity and the integration correction factor.

EP 4 024 041 A1

# FIG.2

Obtaining a NMR relaxation spectrum of the rock sample in impregnated with liquid and a measured porosity — 110

120 —

Identification of the first peak in the NMR relaxation spectrum — 122

Subtraction of the first peak in the NMR relaxation spectrum to obtain the first decorrelated NMR relaxation spectrum — 124

130 —

Indentification of the second peak in the first decorrelated NMR relaxation spectrum — 132

Subtraction of the second peak in the decorrelated NMR relaxation spectrum to obtain the second decorrelated NMR relaxation spectrum — 134

140 —

Calculating a contribution of pore's liquid in the NMR relaxation spectrum — 142

Determining a NMR integration correction factor — 144

Estimating a porosity n' of the geological formation — 146

Calculating a modified porosity n" by applying a corrector factor — 148

**Description**

The present disclosure concerns a method for porosity estimation of a sample rock from a NMR relaxation spectrum.

The present disclosure also concerns a device for porosity estimation implementing the aforementioned method

The present disclosure additionally relates to a computer program comprising software instructions, which implement a method for porosity estimation, when a computer executes them.

The method is in particular aimed at obtaining the porosity estimation of shale rocks extracted from a subsoil.

When drilling a well, information is extracted from the wellbore in order to obtain a better knowledge of different parameters of the formation, such as composition, porosity, liquid filling the formation. The target is to determine if oil or gas can be safely and profitably produced in the area.

Mud logging consists in analyzing at the surface the material recovered from the wellbore such as the drilling liquid and/or rock samples carried by the drilling liquid, also designated as "drill cuttings".

The drill cuttings coming from the wellbore are generally analyzed according to different analysis systems, such as microscope, infrared spectroscopy systems, etc., in order to derive information from this sample.

A method that has been considered for deriving porosity information from a rock sample is using NMR (Nuclear Magnetic Resonance) relaxation spectrum, using the T1-relaxation time or the T2-relaxation time. Using the T2-relaxation time, a NMR relaxation spectrum is achieved in less than 3 minutes and provides a value of the liquid mass present within the sample.

The analysis of NMR transverse (or T2) relaxation signal can provide a sensitive and accurate value of the amount of liquid located inside of the measurement cell by comparison to a reference. The recent development of rare-earth magnets and high frequency electronics technologies leads to the availability of low-cost compact NMR spectrometers, which can be used everywhere as soon as an electrical plug is available.

Therefore, cuttings issued from the mud logging analysis may be analyzed using NMR to provide highly valuable porosity data. The data quality is however strongly linked to the selection of cuttings and their preparation in order to carefully remove all liquid located outside the pieces of rock without removing the liquid located inside of the cuttings. Otherwise this would lead to erroneous evaluation of porosity.

Different methods have been suggested to remove liquid located in the inter-cuttings space and liquid films over the surface of each cutting and capillary menisci of rough surface created by large grains.

Another approach does not need to physically remove liquid located in the inter-cuttings space and free liquid over the surface of each cutting but in removing numerically the effect of these liquids in the NMR relaxation spectrum for the porosity estimation.

When proceeding to T1-NMR measurement or T2-NMR measurement of a rough rock sample, i.e. sample that still have liquid in the inter-cuttings and free liquid over its surface, the obtained amplitude in function of relaxation time makes appear several peaks with a potential overlapping and perturbation due to the contribution of excess of free liquid over its surface.

WO 2019/032783 A1 discloses methods for decorrelating the contribution of free liquid at the surface of the sample from the contribution of liquid trapped in the sample, in a NMR relaxation spectrum.

The methods disclosed in this document are not entirely satisfactory. Indeed, they assume that except the free liquid at the surface of the sample, all measured liquids are located in pores. In addition, they require several experiments leading to considerably long time.

An object of the present disclosure is to suggest a method and a related device for porosity estimation, which is more precise than existing methods, yet being simple to carry out.

For this purpose, the subject matter of the present disclosure a method for porosity estimation of a geological formation, implemented in a porosity estimation device, comprising:

- obtaining data of an initial NMR relaxation spectrum of a rock sample taken from the geological formation, wherein the rock sample includes cuttings and liquid and obtaining a measured porosity;
- decorrelating a first contribution peak of free liquid and inter-cuttings liquid contained in the rock sample from the initial NMR relaxation spectrum to obtain a first decorrelated NMR relaxation spectrum;
- further decorrelating at least a second contribution peak of saturating liquid into a disturbed rock part of cuttings in the first decorrelated NMR relaxation spectrum to obtain at least a second decorrelated NMR relaxation spectrum representative of pore's liquid disposed in intact pieces of rock of the cuttings;
- calculating a contribution of the pore's liquid in the initial NMR relaxation spectrum based on the second decorrelated NMR relaxation spectrum;
- determining a NMR integration correction factor from the contribution of the pore's liquid in the rock sample; and
- estimating an estimated porosity of the geological formation, using the measured porosity and the NMR integration correction factor.

The method of the present disclosure may comprise one or more of the following features:

- decorrelating a first contribution peak of free liquid comprises identifying from the highest relaxation time an onset of the first contribution peak and a maximum of the first peak, calculating a shape of the first contribution peak, and subtracting the first contribution peak from the initial NMR relaxation spectrum;

- calculating a shape of the first contribution peak comprises determining a second region of the first contribution peak by taking the symmetrical of a first region of the first contribution peak extending from the onset of the first contribution peak to the maximum of the first contribution peak;
- calculating a shape of the first contribution peak comprises adding an asymmetrical coefficient to the second region of the first contribution peak;
- decorrelating at least a second contribution peak of liquid contained into the disturbed rock part of cuttings comprises determining from the highest relaxation time an onset of the second contribution peak and a maximum of the second contribution peak, calculating a shape of the second contribution peak, and subtracting the second contribution peak from the first decorrelated NMR relaxation spectrum;
- calculating a shape of the second contribution peak comprises determining a second region of the second contribution peak by taking the symmetrical of a second region of the second contribution peak extending from the onset of the second contribution peak to the maximum of the second contribution peak;
- calculating a shape of the second contribution peak comprises adding an asymmetrical coefficient to the second region of the second contribution peak;
- decorrelating at least a second contribution peak, comprises successively decorrelating a plurality of second contribution peaks advantageously until all second contribution peaks beyond a predetermined relaxation time have been decorrelated;
- the cuttings contains shale or a hard low porous rock;
- the initial NMR relaxation spectrum is a T1 or T2 relaxation spectrum;
- during the calculation sub-step, the contribution of pore's liquid, in the initial NMR relaxation spectrum is a first area below the second decorrelated NMR relaxation spectrum,

  - during the determining sub-step, a second area below the initial NMR relaxation spectrum being calculated, and
  - the integration correction factor being determined as the ratio between the first area and the second area;

- a second calculation sub-step, after the estimating sub-step, of a modified porosity from the estimated porosity and a predefined corrector factor representative of the liquid in the pores present in the disturbed part of cuttings,
- a measuring step of the initial NMR relaxation spectrum of the rock sample and the measured porosity of the rock sample.

The disclosure also concerns a device for porosity estimation of a geological formation comprising:

- an obtaining unit configured to obtain data of an initial NMR relaxation spectrum of a rock sample taken from the geological formation, wherein the rock sample includes cuttings and liquid and a measured porosity;
- a first decorrelation unit configured to decorrelate a first contribution peak of free liquid and inter-cuttings liquid contained in the rock sample from the initial NMR relaxation spectrum to obtain a first decorrelated NMR relaxation spectrum;

wherein the device comprises :

- a second decorrelation unit configured to decorrelate at least a second contribution peak of saturating liquid into a disturbed rock part of cuttings in the first decorrelated NMR relaxation spectrum obtained from the first decorrelation unit, to obtain at least a second decorrelated NMR relaxation spectrum representative of the pore's liquid disposed in intact cuttings pieces of the rock sample,
- a first calculation module configured to calculate a contribution of the pore's liquid in the initial NMR relaxation spectrum;
- a determination module configured to determine a NMR integration correction factor from the contribution of the pore's liquid;
- an estimation module configured to estimate a porosity of the rock sample, using the measured porosity and the NMR integration factor.

Other features and advantages of the present invention will become more evident from the description of a non-limiting, embodiment of a method for example made in reference in the attached drawings in which:

Figure 1 is a schematic view of porosity estimation system comprising drilling system and a porosity estimation device for estimating porosity of a rock sample,
Figure 2 is a method diagram, according to the present invention, for estimating a porosity of a rock sample, the method being implemented by porosity estimation device of Figure 1;
Figure 3 is a schematic view of a rock sample;
Figure 4 is a schematic view of a piece of cuttings of the rock sample of figure 3;
Figure 5 represents the amplitude of NMR signal in function of T2 relaxation time of a rough sample, of identified contribution of free liquid, and of first decorrelated NMR relaxation spectrum;
Figure 6 represents the amplitude of first decorrelated NMR relaxation spectrum as represented on Figure 4, of identified contributions of inter-cuttings liquid, and of second decorrelated NMR relaxation spectrum; and

Figure 7 represents the estimated porosity in function of a depth of a well, the porosity values being estimated with different methods, the horizontal axis and vertical axis representing respectively the estimated porosity and the depth of the well.

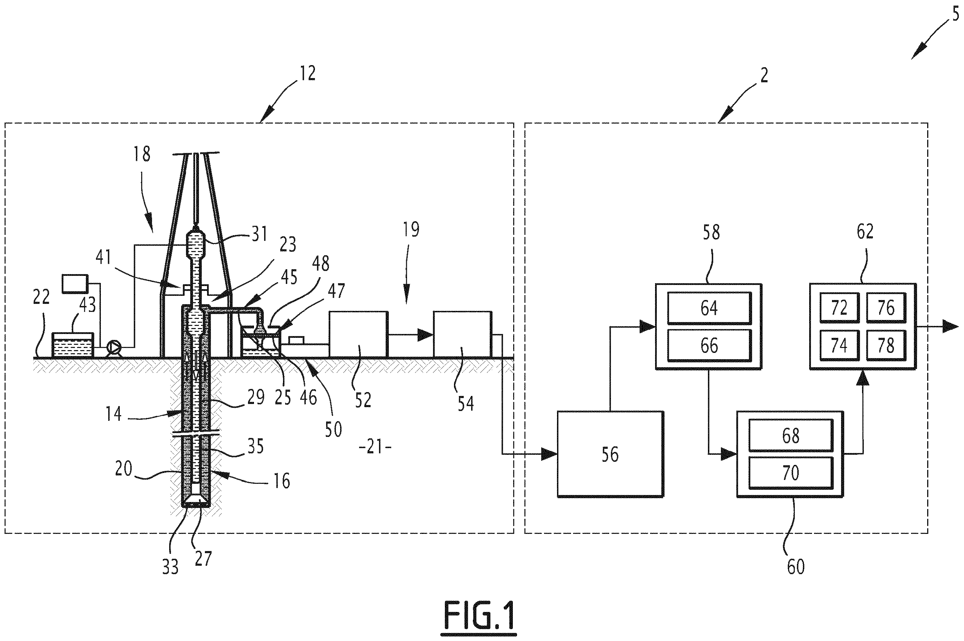

FIG. 1 discloses a device 2 for porosity estimation that may be included in a drilling facility 5.

Such a facility 5 comprises a drilling installation 10, and the device 2 as mentioned above.

In the example of figure 1, the drilling installation 10 comprises a rotary drilling tool 14 able to drill a cavity 16, a surface installation 18, and an analysis unit 19 for analyzing drilling cuttings.

A borehole 20, delimiting the cavity 16, is formed in the substratum (or geological formation) 21 by the rotary drilling tool 14. The geological formation is for example a subsurface formation. At the surface 22, a well head 23 having a discharge pipe 25 closes the borehole 20.

The drilling tool 14 generally comprises a drilling head 27, a drill string 29 and a liquid injection head 31.

The drilling head 27 comprises a drill bit 33 for drilling through the rocks of the substratum 21. It is mounted on the lower portion of the drill string 29 and is positioned in the bottom of the drilling pipe 20.

The drill string 29 comprises a set of hollow drilling pipes. These pipes delimit an internal space 35 which makes it possible to bring a drilling liquid from the surface 22 to the drilling head 27. To this end, the liquid injection head 31 is screwed onto the upper portion of the drill string 29.

The drilling liquid is a drilling mud, in particular a water-based or oil-based drilling mud.

The surface installation 18 comprises a support 41 for supporting the drilling tool 14 and driving it in rotation, an injector 43 for injecting the drilling liquid and a shale shaker 45. The drilling liquid circulates downwards in the inner space 35, getting out of the inner space 35 at the bit 33 and flowing upwards in the cavity 16 to the surface, bringing along drilling residues.

The injector 43 is hydraulically connected to the injection head 31 in order to introduce and circulate the drilling liquid in the inner space 35 of the drill string 29.

The shale shaker 45 collects the drilling liquid charged with the drilling residues, known as drill cuttings, said drilling liquid flowing out from the discharge pipe 25. The shale shaker comprises a sieve 46 allowing the separation of the solid drill cuttings 47 from the drilling mud. The shale shaker 45 also comprises an outlet 48 for evacuating the drill cuttings 47.

The drill cuttings 47 have been separated from the drilling liquid, but, as explained above, they have been mixed with drilling liquid while they were going back to surface for a long time and cuttings could be infiltrating by the drilling liquid or could have their surfaces contaminated by weight materials or additives of the drilling mud.

The analysis system 19 is situated at the outlet of the shale shaker 45 and comprises a sampler 50 for collecting rock fragments of drill cuttings from the outlet 48 of the shale shaker 45 and producing sample rocks; a preparation unit 52 for preparing the samples obtained from the rock fragments for analysis; and an analysis unit 54 for analyzing the samples.

The preparation and analysis units 52 and 54 have been represented here at the well site but may be situated away in any other location, for instance at the well site in a mud logging cabin or remotely from the well site, in which case the collected rock fragments are sent away from the wellbore.

When the preparation and analysis unit are at the well site, it may be possible that all or part of the preparation and analysis operations are automated so as to provided an unmanned analysis system.

The analysis unit 54 comprises one or several analyzers for measuring a porosity value of a given sample. The measured porosity value is obtained from analysis on the entire rock sample. However, as explained below, the rock sample comprises pieces of rock (or cuttings) in different states as well as liquid, making it more challenging to obtain an accurate value of the porosity corresponding to the porosity of the rocks as found in the drilled substratum.

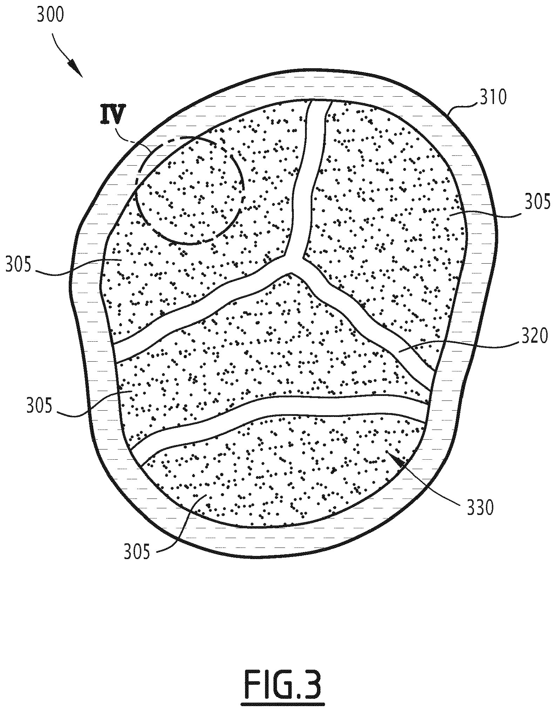

As shown on figure 3, the rock sample 300 indeed includes several cuttings (or pieces of cuttings or rocks) 305 and liquid comprising free liquid 310 at the surface of the rock sample 300, inter-cuttings liquid 320 which is liquid at the interface of cuttings and cuttings liquid 330 which is liquid situated in the cuttings.

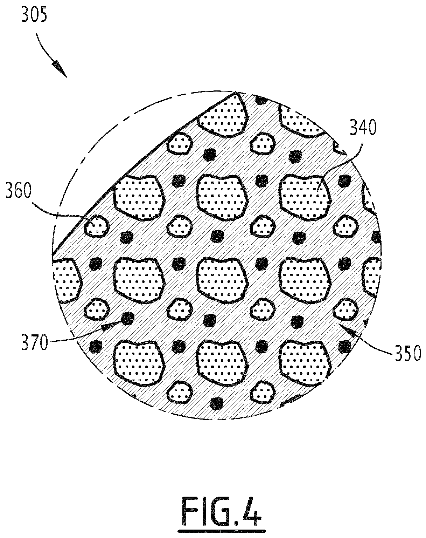

The cuttings may include shale or hard low porous rocks. As shown on figure 4, each piece of cuttings is made of small pieces of intact rock 340 packed by crushed material or disturbed pieces of rock 350 produced by the action of the rotary drilling tool 16. Only the pore's liquid 360 saturating the porosity of pieces of intact rocks must be used to calculate the porosity of drilled substratum as these intact rock pieces correspond to the rocks as they are found in the substratum. The liquid 370 saturating the disturbed material must not be taken into account. The cuttings liquid 330 is the sum of pore's liquid 360 in the pieces of intact rock and the saturating liquid 370 in the disturbed material of each individual cuttings

The analysis unit 54 comprises a Nuclear Magnetic Resonance (NMR) apparatus. For instance, the using of a 20 MHz NMR spectrometer could provide a signal which characterizes liquid located into a sample of any porous rock including weakly bounded water molecules over clay particles. The analysis unit 54 is configured to produce a NMR relaxation spectrum. The NMR relaxation spectrum being optionally obtained by applying a Carr-Purcell-Meiboom-Gill (CPMG) sequence experiment to the sample rock. The NMR relaxation spectrum is a transverse relaxation spectrum also known as spin-spin relaxation measurement or T2-relaxation spectrum.

The device for porosity estimation 2 comprises at least a calculator comprising at least a processor and a memory (not represented on figure 1). The memory contains software modules and/or units adapted to be executed by the processor. Alternatively, the modules are designed at least partially as logic programmable component, or as dedicated integrated circuits.

In the example of figure 1, the memory contains a data obtaining unit 56, a first decorrelation unit 58, a second decorrelation unit 60 and an estimation unit 62. The device for porosity estimation 2 connected to the output of the analysis unit 54, is configured to produce a porosity estimation of a sample rock.

The obtaining unit 56 is configured to obtain data of an initial NMR relaxation spectrum and a raw measured porosity value *n* of a sample rock. The raw measured porosity *n* is obtained by a total mass of fluid (310+320+330), $M_f$, in the rock sample 300 defined by the initial NMR relaxation spectrum, a total mass of the sample, $M_t$, a density of the solid phase of the rock, $\gamma_s$ and a density of the fluid $\gamma_f$, for example according to the following formula:

$$n = \frac{\dfrac{M_f}{\gamma_f}}{\left(\dfrac{M_f}{\gamma_f} + \dfrac{M_s}{\gamma_s}\right)} \quad (1)$$

The total mass of fluid $M_f$ is obtained using the area under the NMR relaxation spectrum and a calibration curve, as already known in the art. The total mass of fluid represent the sum of the masses of the free liquid 310, the inter-cuttings liquid 320 and the cuttings liquid 330.

The initial NMR relaxation spectrum comprises the contributions of free liquid 310, inter-cuttings liquid 320, the saturating liquid 370 and pore's liquid 360. The free liquid 310 and inter-cuttings liquid 320 have generally the contribution with the highest relaxation time while the pore's liquid 360 has generally the contribution with the lowest relaxation time.

The obtaining unit 56 is for instance, configured to receive the data of the initial NMR relaxation spectrum of the rock sample 300, and the measured porosity *n* from the analysis unit 54 via line-based communication.

The first decorrelation unit 58 is configured to produce a first decorrelated NMR relaxation spectrum from the data of initial NMR relaxation spectrum received from the obtaining unit 56.

The first decorrelation unit 58 comprises a first identification module 64 and a first subtraction module 66.

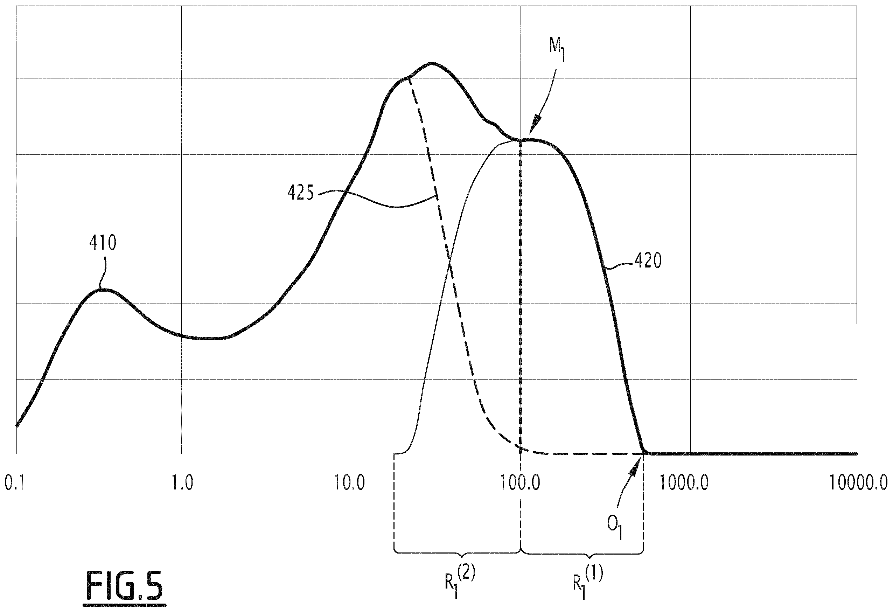

The first identification module 64 is configured to identify a first contribution peak 420 of free liquid 310 and inter-cuttings liquid 320 contained in the rock sample 300, from the initial NMR relaxation spectrum 410 with an example shown for illustration on FIG. 5. The first identification module is configured to determine on the initial NMR relaxation spectrum 420, from the highest relaxation time, an onset $O_1$ of the first peak and a maximum $M_1$ of the first peak 420. The shape of the initial NMR relaxation spectrum between the maximum $M_1$ of the first peak 420 and the highest non-nil point relaxation time (corresponding to the onset $O_1$) is called the first region

$$R_1^{(1)}$$

of the first peak 420.

The first identification module 64 is also configured to calculate a shape of the first peak 420 by determining a second region $R_1^{(2)}$ of the first peak 420 as the symmetrical of the first region $R_1^{(1)}$ of the first peak 420 extending from the onset $O_1$ of the first peak to the maximum of the first peak 420. Other ways of determining the shape of the second region $R_1^{(2)}$ will be described thereafter.

The first subtraction module 66 is configured to subtract the first contribution peak 420 of free liquid 310 and inter-cuttings liquid 320 identified by the first identification module, from the initial NMR relaxation spectrum 410, to produce a first decorrelated NMR relaxation spectrum 425.

The first decorrelated NMR relaxation 425 spectrum is substantially devoid of free liquid 310 and inter-cuttings liquid 320 contributions.

The second decorrelation unit 60 is configured to provide a second decorrelated NMR relaxation spectrum 440. The second decorrelation unit 60 comprises a second identification module 68 and a second subtraction module 70.

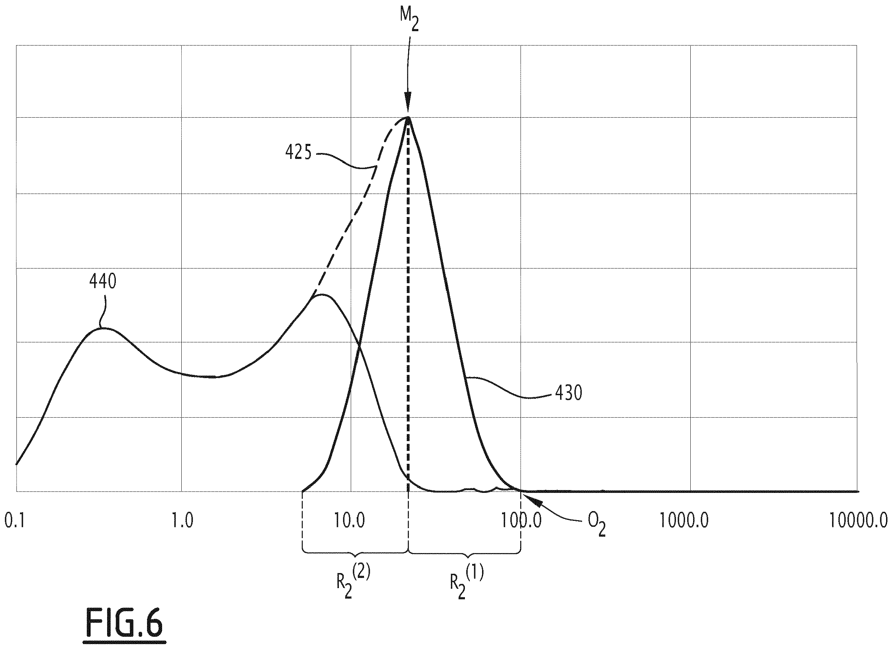

The second identification module 68 is configured to identify at least a second contribution peak 430 of saturating liquid 370 contained in the disturbed material part of cuttings from the first decorrelated NMR relaxation spectrum 425 illustrated on FIG. 5 and 6. The second identification module 68 is configured to determine on the first decorrelated NMR relaxation spectrum 425, from the highest relaxation time an onset $O_2$ of the second peak and a maximum $M_2$ of the second peak 430. The shape of the first decorrelated NMR relaxation spectrum 425 between the maximum $M_2$ of the second peak 430 and the highest non-nil point relaxation time is denoted the first region $R_2^{(1)}$ of the second peak 430.

The second identification 68 module is also configured to calculate the shape of the second peak 430 by determining a second region $R_2^{(2)}$ of the second peak 430 advantageously as the symmetrical of the first region

$R_2^{(2)}$ of the second peak 430 extending from the onset $O_2$ of the second peak 430 to the maximum $M_2$ of the second peak 430. Other ways of determining the shape of the second region $R_2^{(2)}$ will be described below.

The second subtraction module 70 is configured to subtract the or each second contribution peak 430 of saturating liquid 370 identified by the second identification module 68, from the first decorrelated NMR relaxation spectrum 425, leading to a second decorrelated NMR relaxation spectrum 440.

The second decorrelated NMR relaxation spectrum 440 is substantially devoid of saturating liquid 370 contribution of disturbed material of cuttings. It only comprises the contribution of the pore's liquid 360, i.e. liquid disposed in the intact pieces of rock 340.

The estimation unit 62 is configured to estimate the porosity n' of the rock sample 300, from the second decorrelated NMR spectrum 440 produced by the second decorrelation unit.

The estimation unit 62 comprises a first calculation module 72, a determination module 74 and an estimation module 76.

The first calculation module 72 is configured to calculate a contribution of the pore's liquid 360 in the initial NMR relaxation spectrum 410 from the second decorrelated NMR spectrum 440 calculated by the second subtraction module 70. The first calculation module 72 is for example configured to calculate a first area corresponding to the area below the second decorrelated NMR relaxation spectrum 440.

The determination module 74 is configured to determine a NMR integration correction factor $\alpha$.

The determination module 74 is for example, configured to compute a second area corresponding to the area below the initial NMR relaxation spectrum and to determine the NMR integration correction factor $\alpha$ as the ratio between the first area and the second area.

The estimation module 76 is configured to calculate an estimated porosity n' of a rock sample 300 from a measured porosity n obtained by the obtaining unit 56, and the integration correction factor $\alpha$ determined by the determination module 74.

The estimation module 76 is for example configured to estimate the estimated porosity n' of the rock sample 300 according to the following equation:

$$ n' = \frac{\alpha n}{(1+n)(1-\alpha)} \ (2) $$

The memory optionally comprises a second calculation module 78 which is configured to apply a predefined corrector factor $\beta$ to the estimated porosity n' to take into account the presence of original pores into some particles which form the matrix (or disturbed material) between the pieces of intact rock 340 in the cuttings 305.

The second calculation 78 module is for instance, configured to compute a modified porosity n" according the following equation:

$$ n'' = \beta n' \ (3) $$

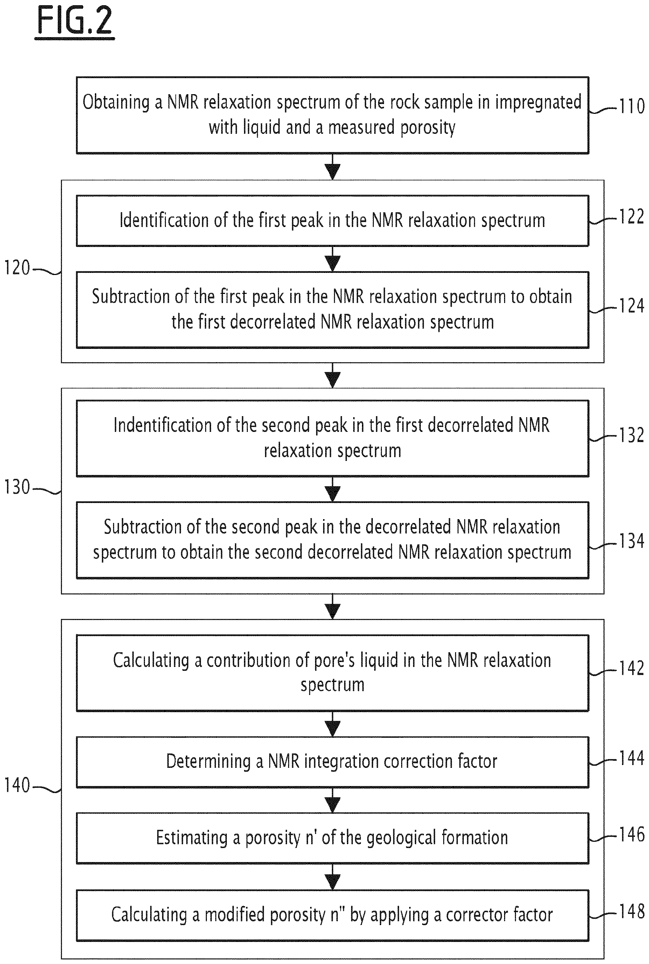

A method for porosity estimation implemented in the previously described device for porosity estimation 2 will now be described with reference to figure 2 and figure 4.

Initially, during a measuring step, the initial NMR relaxation spectrum 410 and the measured porosity n are measured. The initial NMR relaxation spectrum comprises data.

At the obtaining step 110, the device for porosity estimation obtains the data of the initial NMR relaxation spectrum 410 and a measured porosity n, via the obtaining unit 56. Figure 5 and Figure 6 depict the amplitude of several NMR relaxation spectra in function of the T2 relaxation time in millisecond. On Figure 4, the curve 410 shows the initial NMR relaxation signals.

Then, at the first decorrelation step 120, the device for porosity estimation 2 decorrelates in the initial NMR relaxation spectrum 410, the contribution of free liquid 310 and inter-cuttings liquid 320 from the contribution of cuttings liquid 330, via the first decorrelation unit 58 as explained in relationship with FIG. 5. This step is fulfilled through at least two sub-steps; a first identification sub-step 122, a first subtraction sub-step 124.

During the first identification sub-step 122, the device for porosity estimation 2 identifies a first contribution peak 420 of free liquid 310 and inter-cuttings liquid 320 contained in the rock sample 300, via the first identification module 64. During the first identification sub-step 122, the device for porosity estimation 2 determines for example, from the highest relaxation time the onset $O_1$ of the first peak 420 and the maximum $M_1$ of the first peak 420.

Still during the first identification sub-step 122, the device for porosity estimation 2 determines the first region $R_1^{(1)}$ of the first peak 420 as shape of the initial NMR relaxation spectrum 410 between the maximum $M_1$ of the first peak 420 and the non-nil point with the highest relaxation time. This determination leads for instance, to a first analytical model that fits the initial NMR relaxation spectrum in the first region $R_1^{(1)}$ of the first peak 420.

Also, during the first identification sub-step 122, the device for porosity estimation 2 calculates the shape of the first peak by determining the second region of the first peak advantageously as the symmetrical of the first region of the first peak extended from the onset of the first peak to the maximum of the first peak.

During the first subtraction sub-step 124, the device for porosity estimation 2 subtracts, via its first subtraction module 66, the first contribution peak 420 of free liquid 310 and inter-cuttings liquid 320 from the initial NMR relaxation spectrum 410. This subtraction leads to a first decorrelated NMR relaxation spectrum 425.

The device for porosity estimation 2 goes now to the second decorrelation step 130 to produce the second decorrelated NMR relaxation 440 spectrum from the first decorrelated NMR relaxation spectrum 425 as shown on Figure 6. The second decorrelation step 130 comprises at least two sub-steps: the second identification sub-step 132 and the second subtraction sub-step 134.

During the second identification sub-step 132, the device for porosity estimation 2 identifies at least one the second contribution peak 430 of liquid contained in disturbed part of cuttings 370, via its second identification module 68. During the second identification sub-step 132, the device for porosity estimation 2 determines for example, from the highest relaxation time the onset $O_2$ of the second peak 430 and the maximum $M_2$ of the second peak 430.

Then the device for porosity estimation 2 determines the first region $R_2^{(1)}$ of the second peak 430 as shape of the first decorrelated NMR relaxation spectrum 425 between the maximum $M_2$ of the second peak 430 and the non-nil point with the highest relaxation time. This determination leads for instance, to the second analytical model that fits the first decorrelated NMR relaxation spectrum 425 in the first region $R_2^{(1)}$ of the second peak.

Still during the second identification sub-step 132, the device for porosity estimation 2 calculates the shape of the second peak 430 by determining the second region $R_2^{(2)}$ of the second peak 430 advantageously as the symmetrical of the first region $R_2^{(1)}$ of the second peak 430 extending from the onset $O_2$ of the second peak 430 to the maximum $M_2$ of the second peak 430.

During the second subtraction sub-step 134, the device for porosity estimation 2 subtracts, via its second subtraction module 70, the second contribution peak 430 of disturbed part of cuttings, from the first decorrelated NMR relaxation spectrum 425. This subtraction leads to a second decorrelated NMR relaxation spectrum 440

At the estimation step 140, the device for porosity estimation estimates the porosity of the rock sample 300 from the measured porosity $n$, the initial NMR relaxation spectrum and the second decorrelated NMR relaxation spectrum, via its estimation unit 62.

The estimation step 140 comprises at least three sub-steps: a first calculation sub-step 142, a determination sub-step 144, and an estimation sub-step 146.

During the first calculation sub-step 142, the device for porosity estimation 2 calculates an area below the second decorrelated NMR relaxation spectrum 440, designated above as first area. This area corresponds to the contribution of pore's liquid 360 in the initial NMR relaxation spectrum 410.

During the determination sub-step 144, the device for porosity estimation 2 determines, via its determination module 64, the integration correction factor $\alpha$ from the contribution of the pore's liquid 360. To do so, the device for porosity estimation 2 calculates for example a second area corresponding to the area below the initial NMR relaxation spectrum 410.

Still during the determination sub-step 144, the device for porosity estimation 2 determines the integration correction factor $\alpha$ for example by determining the ratio between the first area and the second area.

During the estimation sub-step 146, the device for porosity estimation 2 estimates, via its estimation module 76, the porosity $n'$ of the geological formation (corresponding to the porosity of the pieces of intact rock 340) from the measured porosity $n$ of the rocksample 300 for example according to the above mentioned equation (1) and the integration correction factor $\alpha$, for example according to the above mentioned equation (2).

The estimation sub-step 146 optionally comprises a fourth sub-step: a second calculation sub-step 148.

During the second calculation sub-step 148, the device for porosity estimation 2 calculates, via its optional second calculation module 78, a modified porosity $n''$ by applying a predefined corrector factor $\beta$ to the estimated porosity $n'$ according, for example to the above mentioned equation (3).

With the method for porosity estimation, according to the disclosure, the porosity estimation is more precise and simple to carry out.

Figure 6 shows the evolution of measured and estimated porosity according to several methods, in function of a depth of a well. The horizontal axis represents the porosity value while the vertical axis represents the depth of the well in which one mark corresponds to 100 feet.

The first thin curve 510 represents the evolution of the porosity measured from the cuttings. This porosity measurement is one input of the method according to the disclosure.

The dotted curve 520 is the porosity estimated after removing in the initial NMR relaxation spectrum, the first peak relying to the free liquid 310 and inter-cuttings liquid 320. Figure 6 highlights the improvement of such a removal which has the same effect than the method disclosed in WO 2019/032783 A1.

The dashed curve 530 is the estimated porosity with the method according to the disclosure. Such estimated porosity are generally lower than the values observed on the first thin curve 510 and the dotted curve 520.

The very thick curve 540 is the measured porosity using wire logging NMR relaxation method. This method is known to be more precise than the measurement on the cuttings.

The thick curve 550 is the measured porosity using a density method known to be even more precise than the NMR method but more expensive to perform.

The second thin curve 560 represents the measured porosity using neutron method. This method is known to be one of the most precise method. However, this method is one of the most expensive and one of the most time consuming method to perform.

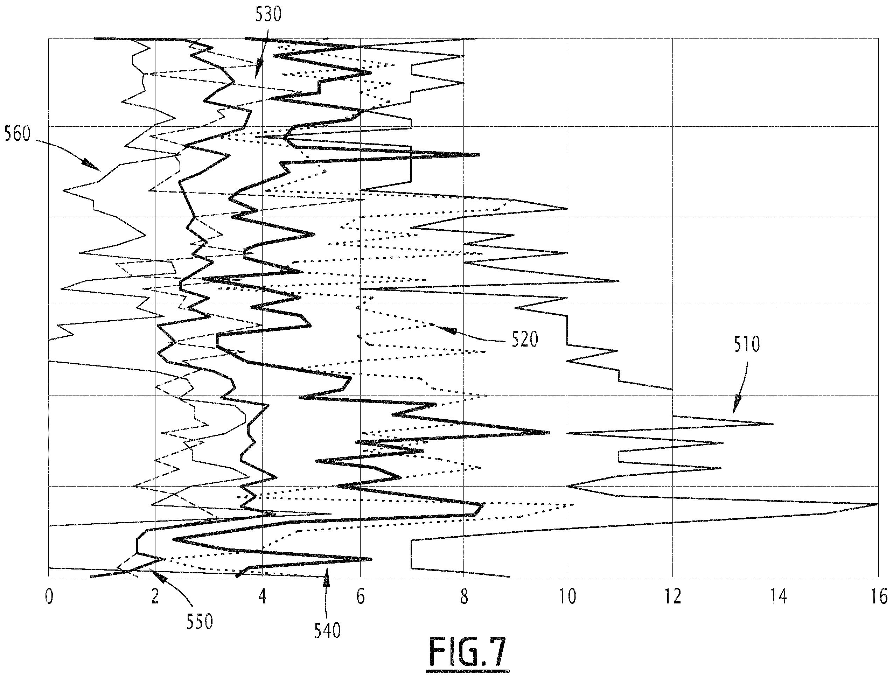

Figure 7 highlights that estimated porosity with the method for porosity estimation according to disclosure is generally close to the estimated porosity with the density method and even close to the estimated porosity with the neutron method at some points. Yet the method for porosity estimation according to the disclosure is simpler and cheaper to carry out.

In addition, the method according to the disclosure does not require cleaning the sample to remove free liquid 310 and inter-cuttings liquid 320, before proceeding to measurement. This leads to a time reduction of porosity estimation. In addition, this prevents from risks to crush the samples and to break the pores.

Moreover, compared to methods disclosed in WO 2019/032783, the method for porosity estimation according to the disclosure only require one measurement of NMR relaxation spectrum making the method according to the disclosure simpler.

In a variant, during first 122 and the second 124 identification sub-step, when calculating the shape of the first, respectively the second, peak, an asymmetrical coefficient is added to the second region of the first, respectively the second, peak. The first and the second identification modules are also configured to add the asymmetrical coefficient to the second region of the first, respectively second, peak.

In a variant, several second peaks can be subtracted from the first decorrelated NMR spectrum, to eliminate contributions in a given relaxation time interval, for example, for T2 relaxation time comprised between the conventional cut-off values of 33 and 512 ms corresponding to fluid not located into pores defined by clays.

The method comprises separating sub-steps 132 and 134, once an initial second peak has been subtracted from the first decorrelated NMR spectrum, to determine and subtract at least an additional second peak, until all peaks above a predetermined T2 relaxation time have been subtracted.

In a variant, the device for porosity estimation 2 is not physically located in the drilling installation 10 for porosity estimation. The device for porosity estimation 2 is able to obtain the initial NMR relaxation spectrum and the raw measured porosity $n$ from its obtaining unit 56 via wireless communication.

In another variant, the NMR relaxation spectrum is a T1 relaxation spectrum.

## Claims

1. Method for porosity estimation of a geological formation, implemented in a porosity estimation device, comprising:

   - obtaining (110) data of an initial NMR relaxation spectrum (410) of a rock sample (300) taken from the geological formation, wherein the rock sample includes cuttings (305) and liquid and obtaining a measured porosity ($n$);
   - decorrelating (120) a first contribution peak of free liquid (310) and inter-cuttings liquid (320) contained in the rock sample (300) from the initial NMR relaxation spectrum (410) to obtain a first decorrelated NMR relaxation spectrum (425);
   - further decorrelating (130) at least a second contribution peak (430) of saturating liquid (370) into a disturbed rock part of cuttings (350) in the first decorrelated NMR relaxation spectrum (425) to obtain at least a second decorrelated NMR relaxation spectrum (440) representative of pore's liquid (360) disposed in intact pieces of rock (340) of the cuttings (305);
   - calculating (142) a contribution of the pore's liquid (360) in the initial NMR relaxation spectrum (410) based on the second decorrelated NMR relaxation spectrum (440);
   - determining (144) a NMR integration correction factor ($\alpha$) from the contribution of the pore's liquid (360) in the rock sample (300); and
   - estimating (146) an estimated porosity (n') of the geological formation, using the measured porosity ($n$) and the NMR integration correction factor ($\alpha$).

2. Method for porosity estimation according to claim 1, wherein decorrelating (130) a first contribution peak (420) of free liquid (310) comprises identifying (122) from the highest relaxation time an onset $O_1$ of the first contribution peak (420) and a maximum $M_1$ of the first peak, calculating a shape of the first contribution peak (420), and subtracting (124) the first contribution peak (420) from the initial NMR relaxation spectrum (425).

3. Method for porosity estimation according to claim 2, wherein calculating a shape of the first contribution peak (420) comprises determining a second region $\left(R_1^{(2)}\right)$ of the first contribution peak (420) by taking the symmetrical of a first region $\left(R_1^{(1)}\right)$ of the first contribution peak (420) extending from the onset ($O_1$) of the first contribution peak (420) to the maximum ($M_1$) of the first contribution peak (420).

4.  Method for porosity estimation according to claim 3, wherein calculating a shape of the first contribution peak (420) comprises adding an asymmetrical coefficient to the second region $\left(R_1^{(2)}\right)$ of the first contribution peak (420).

5.  Method for porosity estimation according to any one of the preceding claims, wherein decorrelating at least a second contribution peak (430) of liquid contained into the disturbed rock part of cuttings (370) comprises determining from the highest relaxation time an onset ($O_2$) of the second contribution peak (430) and a maximum ($M_2$) of the second contribution peak (430), calculating a shape of the second contribution peak (430), and subtracting the second contribution peak (430) from the first decorrelated NMR relaxation spectrum (425).

6.  Method for porosity estimation according to claim 5, wherein calculating a shape of the second contribution peak (430) comprises determining a second region $\left(R_2^{(1)}\right)$ of the second contribution peak (430) by taking the symmetrical of a second region $\left(R_2^{(2)}\right)$ of the second contribution peak (430) extending from the onset ($O_2$) of the second contribution peak (430) to the maximum ($M_2$) of the second contribution peak (430).

7.  Method for porosity estimation according to claim 6, wherein calculating a shape of the second contribution peak (430) comprises adding an asymmetrical coefficient to the second region $\left(R_2^2\right)$ of the second contribution peak (430).

8.  Method for porosity estimation according to any one of the preceding claims, wherein decorrelating at least a second contribution peak (430), comprises successively decorrelating a plurality of second contribution peaks (430) advantageously until all second contribution peaks (430) beyond a predetermined relaxation time have been decorrelated.

9.  Method for porosity estimation according to any one of the preceding claims, wherein the cuttings (305) contains shale or a hard low porous rock (300).

10. Method for porosity estimation according to any one of the preceding claims, wherein the initial NMR relaxation spectrum (410) is a T1 or T2 relaxation spectrum.

11. Method for porosity estimation according to any one of the preceding claims, wherein, during the calculation sub-step (142), the contribution of pore's liquid, in the initial NMR relaxation spectrum (410) is a first area below the second decorrelated NMR relaxation spectrum (440),
during the determining sub-step (144), a second area below the initial NMR relaxation spectrum (410) is calculated,
and the integration correction factor ($\alpha$) is determined as the ratio between the first area and the second area.

12. Method for porosity estimation according to any one of the preceding claims, comprising a second calculation sub-step (148), after the estimating sub-step (146), of a modified porosity ($n''$) from the estimated porosity ($n'$) and a predefined corrector factor ($\beta$) representative of the liquid in the pores present in the disturbed part of cuttings (350).

13. Method for porosity estimation according to any one of the preceding claims, comprising a measuring step of the initial NMR relaxation spectrum of the rock sample (300) and the measured porosity ($n$) of the rock sample.

14. Device (2) for porosity estimation of a geological formation comprising:

    - an obtaining unit (56) configured to obtain data of an initial NMR relaxation spectrum (410) of a rock sample (300) taken from the geological formation, wherein the rock sample (300) includes cuttings (305) and liquid and a measured porosity ($n$);
    - a first decorrelation unit (58) configured to decorrelate a first contribution peak (420) of free liquid (310) and inter-cuttings liquid (320) contained in the rock sample (300) from the initial NMR relaxation spectrum (410) to obtain a first decorrelated NMR relaxation spectrum (425);

    wherein the device (2) comprises :

    - a second decorrelation unit (60) configured to decorrelate at least a second contribution peak (430) of saturating liquid (370) into a disturbed rock part of cuttings (350) in the first decorrelated NMR relaxation spectrum (425) obtained from the first decorrelation unit, to obtain at least a second decorrelated NMR relaxation spectrum (440) representative of the pore's liquid (360) disposed in intact cuttings pieces (340) of the rock sample,
- a first calculation module (72) configured to calculate a contribution of the pore's liquid (360 in the initial NMR relaxation spectrum (410);
- a determination module (74) configured to determine a NMR integration correction factor ($\alpha$) from the contribution of the pore's liquid (360);
- an estimation module (76) configured to estimate a porosity ($n'$) of the rock sample (300), using the measured porosity ($n$) and the NMR integration factor ($\alpha$).

FIG.1

# FIG.2

Obtaining a NMR relaxation spectrum of the rock sample in impregnated with liquid and a measured porosity ⎯110

Identification of the first peak in the NMR relaxation spectrum ⎯122

120⎯

Subtraction of the first peak in the NMR relaxation spectrum to obtain the first decorrelated NMR relaxation spectrum ⎯124

Indentification of the second peak in the first decorrelated NMR relaxation spectrum ⎯132

130⎯

Subtraction of the second peak in the decorrelated NMR relaxation spectrum to obtain the second decorrelated NMR relaxation spectrum ⎯134

Calculating a contribution of pore's liquid in the NMR relaxation spectrum ⎯142

Determining a NMR integration correction factor ⎯144

140⎯

Estimating a porosity n' of the geological formation ⎯146

Calculating a modified porosity n" by applying a corrector factor ⎯148

**FIG.3**

305

340

360

370

350

FIG.4

FIG.5

EP 4 024 041 A1

EP 4 024 041 A1

FIG.6

FIG.7

Europäisches
Patentamt

European
Patent Office

Office européen
des brevets

# EUROPEAN SEARCH REPORT

Application Number

EP 20 30 6709

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X,O | Billiotte Joel ET AL: "Automated Determination of Formation Porosity from Drill Cuttings using Nuclear Magnetic Resonance", 2019 Annual Symposium of the Society of Core Analysts, 26 August 2019 (2019-08-26), pages 1-1, XP055812899, Pau, France Retrieved from the Internet: URL:http://jgmaas.com/SCA/2019/SCA2019-054.pdf [retrieved on 2021-06-11] * the whole document * | 1-14 | INV. G01N24/08 ADD. G01R33/44 |
| L | -& Green D.: "Core Analysis in a Digital World - Final Program", , 26 August 2019 (2019-08-26), pages 1-40, XP055812896, Internet Retrieved from the Internet: URL:https://www.e3s-conferences.org/articles/e3sconf/pdf/2020/06/e3sconf_SCA2019_About.pdf [retrieved on 2021-06-11] * The document establishes the publication date of the conference abstract of the first citation. * ----- -/-- | | |

TECHNICAL FIELDS SEARCHED (IPC)

G01N
G01R

The present search report has been drawn up for all claims

| Place of search | Date of completion of the search | Examiner |
|---|---|---|
| Munich | 14 June 2021 | Skalla, Jörg |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

page 1 of 2

Europäisches
Patentamt

European
Patent Office

Office européen
des brevets

# EUROPEAN SEARCH REPORT

Application Number

EP 20 30 6709

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | KESSERWAN HASAN ET AL: "SPE-188881-MS Porosity Measurements on Drill Cuttings -Comprehensive Inputs to Formation Evaluation near Real-Time While Drilling", ABU DHABI INTERNATIONAL PETROLEUM EXHIBITION & CONFERENCE, [Online] 13 November 2017 (2017-11-13), pages 1-10, XP055812922, Internet Retrieved from the Internet: URL:https://www.researchgate.net/publicati on/321014299_Porosity_Measurements_on_Dril l_Cuttings_-_Comprehensive_Inputs_to_Forma tion_Evaluation_Near_Real-Time_While_Drill ing> [retrieved on 2021-06-11] | 1,2,5, 8-11,13, 14 | |
| A | * page 3 - page 4 * | 3,4,6,7, 12 | |
| | ----- | | |
| A | AKIHISA KUNIO ET AL: "Integrating mud gas and cuttings analyses to understand local CGR variation in the Montney tight gas reservoir", INTERNATIONAL JOURNAL OF COAL GEOLOGY, ELSEVIER, AMSTERDAM, NL, vol. 197, 19 August 2018 (2018-08-19), pages 42-52, XP085478554, ISSN: 0166-5162, DOI: 10.1016/J.COAL.2018.08.005 * figure 8 * | 1-14 | TECHNICAL FIELDS SEARCHED (IPC) |
| | ----- | | |

The present search report has been drawn up for all claims

| Place of search | Date of completion of the search | Examiner |
|---|---|---|
| Munich | 14 June 2021 | Skalla, Jörg |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

page 2 of 2

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2019032783 A1

- WO 2019032783 A